# EUROPEAN PATENT SPECIFICATION

(11) **EP 2 405 487 B1**
(45) Date of publication and mention of the grant of the patent: **02.12.2020**
(21) Application number: 10751068.7
(22) Date of filing: 26.02.2010
(51) Int. Cl.: H01L 31/04

(54) **A PHOTO-CONVERTING PART OF AN ELECTROMAGNETIC RADIATION CONVERTER (VARIANT EMBODIMENTS), AND AN ELECTROMAGNETIC RADIATION CONVERTER**
LICHTUMWANDLUNGSTEIL EINES ELEKTROMAGNETISCHEN STRAHLUNGSWANDLERS (MÖGLICHE AUSFÜHRUNGEN) UND ELEKTROMAGNETISCHER STRAHLUNGSWANDLER
PARTIE DE CONVERSION PHOTOÉLECTRIQUE D'UN CONVERTISSEUR DE RAYONNEMENT ÉLECTROMAGNÉTIQUE (ET VARIANTES) ET CONVERTISSEUR DE RAYONNEMENT ÉLECTROMAGNÉTIQUE

(30) Priority: 04.03.2009 RU 2009107568
(43) Date of publication of application: 11.01.2012
(73) Proprietor: Tsoi, Bronya, Moscow, 117342 (RU)
(72) Inventor: BUDISHEVSKY, Jury Dmitrievich, Bryansk 241047 (RU)
(74) Representative: Lemcke, Brommer & Partner Patentanwälte Partnerschaft mbB
(86) International application number: PCT/RU2010/000089
(87) International publication number: WO 2010/104414

(56) References cited:
- RU-A- 2006 120 073
- RU-A- 2007 129 517
- US-A- 4 227 941
- US-A- 4 688 068
- US-A- 5 990 415
- US-A1- 2003 080 280

## Description

### TECHNICAL FIELD

The present invention relates to the electromagnetic radiation (EMR) semiconductor converters for directly converting incident radiation into electromotive force (EMF) both in optically visible and invisible (IR, UV) wavebands and a shorter waveband, and also to the methods for modifying the semiconductor substrate on which said semiconductor converters are formed.

### BACKGROUND ART

The spectral selectivity of conventional photoelectric converters (PEC) based on semiconductor materials comprising a heterogeneous n⁺pp⁺ (p⁺np⁺) diode arrangement is limited, in the long-wave range, by the semiconductor's forbidden band width (FBW) and insufficient diffusion length of the minority carriers in the p(n) base area, and by recombination losses at the photo-converting surface and within the bulk of the solid n⁺ (p⁺) near-surface layer, in the short-wave range. The document US5 990 415A is a relevant prior art.

Improving efficiency and enhancing spectral selectivity of the prior art PEC is achieved using multilayer heterostructures in cascade converters. (Alferov Zh.I., Andreev V.M., Rumyantsev V.D. /Development Trends and Prospects of Solar Power Engineering. //Semiconductor Physics and Technology, 2004, Vol. 38, Issue 8, pages 937-948; Meitin M. / Photovoltaics: Materials, Technologies, Prospects // Electronics: Science, Technology, Business, 2000, No. 6, pages 40-46; Konstantinov P.B., Kontsevoy Yu.A,, Maksimov Yu.A., Silicon Solar Cells, Moscow, MIREA Publishers, 2005, 70 pages.) Such converters require an entire spectrum of incident radiation to modulate the conductivity of each of the layers and are extremely costly despite a low layer-by-layer conversion factor.

In order to extend the convertible spectrum of incident radiation into the short-wave region, the present inventors have earlier proposed a discrete converter arrangement with open undoped optical windows, wherein both high diode properties and optical properties of the converter are combined (PCT/RU 2007/000301, priority date of 08.06.2006). Such arrangement has a higher selectivity in the UV band than the "violet" designs and a higher conversion factor throughout the entire convertible band than the conventional designs.

In order to reduce the surface recombination of the non-equilibrium charge carriers in the converter's photo-converting part, the present inventors have earlier proposed the systems of fields formed using isotype junction(s), deviating electrodes, charges embedded into the antireflection coating dielectric material and combinations of techniques. A high conversion factor in the long-wave region is achieved by increasing the concentration gradients of the non-equilibrium charge carriers (NeCC) as a result of creating lateral gradients directed towards p-n junctions, by concentrating incident radiation within the bulk using microlenses and other techniques disclosed in previous inventions of the present inventors (See, for example, Budishevsky Yu.D., Tsoy B. et al., RU 2006140882, priority date of 21.11.2006 IB No. 15, 27.05.2008, and also an earlier invention by the same inventors published as WO 2007/145546, 21.12.2007)

Known is a vertical multijunction converter structure with vertically extending (parallel to the incident radiation flow) p-n junctions (VMJ-converter), and a method for producing the same, wherein a stack is formed from a large number of separate conventional n⁺pp⁺ single-junction solar cells (plates) (see reference below). The plates in said stack are connected to each other by soldering or diffusion welding. The stack is cut normally to the junction planes into separate VMJ-converters whose front surfaces are polished and coated with a passivating layer and an antireflective layer.

Therefore, the VMJ-converter is formed by mechanically connecting in series the unijunction diodes to exhibit series type connection characteristics of the current elements: the output voltage equal to the sum of voltages generated by each of the PECs, and the output current defined by the minimum current generated by any of the PECs forming the stack. The VMJ-converter's series resistance is equal to the sum of resistances of the PECs forming the stack. Subject to accurate PEC selection, the stack is characterized by a high fill factor value of FF ≈ 0.8 indicative of the possibility in principle to obtain a low series resistance of the converter.

The collection factor of such structures is not dependent on the incident radiation wave length within the range λ = 340-1080 nm. A high carrier collection in the UV region is achieved by that the UV radiation is absorbed in the lightly doped base rather than in the heavily doped emitter. A high collection of minority charge carriers in the IR region is due to a high base lifetime of the charge carriers (A.L.Fahrenbruch, R.H.Bube, Fundamentals of Solar Cells. Solar Energy Conversion (Academic Press, N.Y., 1983), 280 pages//E.G. Guk et al., Characteristics of silicon multijunction solar cells with vertical p-n junctions, FTP, 1997, Volume 31, No. 7).

Possible component layouts in the VMJ-converter enable both parallel and series connection with the p-n junctions being partly switched. A disadvantage of the VMJ-converters is their high production cost inconsistent with their low (∼11%) solar energy conversion efficiency. Therefore, the VMJ-converters have not found widespread application.

The prior art closest to the present invention is a planar multilayer multijunction converter proposed earlier by the present inventors, composed of discrete localized n⁺⁺p⁺n⁺p... structures formed within the common p-base body (See PCT/RU 2008/000490, priority date of 01.08.2007). The limitation of such converter consists in the processing complexity associated with switching the layers in each of the cells and combining the cells into parallel circuits, requiring application of a sequence of photolithographic steps.

### SUMMARY OF THE INVENTION

In view of the foregoing limitations inherent in the prior art solutions, it is an object of the present invention to provide high efficient broadband EMR converters with a high conversion efficiency in a wide range of EMR waves and intensities from IR to UV and lower.

According to a first aspect of the invention, said object is achieved in a photo-converting part of an electromagnetic radiation converter, composed of a sequence of layers forming homogeneous junctions with each other, said sequence comprising more than one different-type junctions as recited in claim 1. Further advantageous embodiments are recited in the dependent claims. Whatever the content of the foregoing description, the scope of the invention is solely as specified by the appended claims.

In what follows, the term "photo-converting part" should be understood as a part of the electromagnetic radiation converter, wherein the charges generated in response to the EMR acting on the converter are caused to separate. The reference made to a sequence of junctions (homogeneous junctions) with an increasing depth means that the junctions are arranged sequentially into the depth of the photo-converting part in the direction from its surface such that the depths Xj₁, Xj₂, Xj₃, Xj₄,..., Xjk of a sequence made of k junctions (k>1) are related to each other by the formula Xj₁ < Xj₂ < Xj₃ < Xj₄ <... < Xjk, where Xj₁ is an outermost junction of the given sequence. The term "comprising [a sequence of semiconductor layers]" as used hereinafter with reference to the converter's photo-converting part shall mean that besides said sequence, the photo-converting part may also have other elements, in particular other layers. The term "semiconductor layers" should be understood as the layers of a semiconductor material having electronic (n-type), hole-type (p-type) or intrinsic (i-type) conductivity.

Furthermore, as it is usual in the relevant art, the term "homojunctions (homogeneous junctions)" should be understood as a junction at the interface between the areas formed of the same semiconductor material with differing conductivity. Accordingly, the term "heterojunctions (heterogeneous junctions) should be understood as the junctions between the areas formed of differing semiconductor materials. The term different-type (anisotype) junction should be understood as a junction formed at the interface between the areas (layers) with differing conductivity types, whereas the term "isotype junction" should be understood as a junction formed at the interface between the areas (layers) with the same conductivity type.

According to a second aspect of the invention, said object is achieved in a photo-converting part of an electromagnetic radiation converter, composed of a sequence of layers forming homogeneous junctions with each other, said sequence comprising more than one different-type junctions and at least some of said layers with the same conductivity type being switched.

As used herein, the term "layer switching" should be understood as a connection of layers to each other by means of additional semiconductor or conductor elements. The term "parallel switching" should be understood as an interconnection of layers forming a parallel circuit. Accordingly, the term "in series switching" should be understood as an interconnection of layers forming a series circuit.

At the same, in various particular embodiments, at least some or all of the hole-type conductivity layers may be switched in series and/or at least some or all of the electronic conductivity layers may be switched in series.

In another particular embodiment, at least one of said layers may be provided with a discontinuity. For the purposes of the present invention, the term "discontinuity" should be understood as any layer interruption and/or removal of at least some of the layer material resulting in a layer with disturbed uniformity and/or continuity, whose discontinued portion will differ from its portion having no discontinuity.

According to another aspect of the invention, its object is achieved in an electromagnetic radiation converter comprising at least M ≥ 1 photo-converting parts, an antireflection coating and current-collecting electrodes, characterized in that at least one of its M photo-converting parts consists of a sequence of layers forming homogeneous junctions with each other, said sequence comprising more than one different-type junctions and at least Z ≥ 0 same conductivity type layers of said converter's photo-converting part are switched in parallel.

At the same, in various particular embodiments, the converter may comprise one photo-converting part of the above type provided on the front side thereof and/or one photo-converting part of the above type on the reverse side thereof (single-sided or double-sided unitary converter).

In other embodiments, the converter may comprise at least on one of its sides several photo-converting parts isolated from one another with at least one of said parts having a multilayer structure of the above type. Said several isolated photo-converting parts may be provided on the converter front side and/or reverse side (single-sided or double-sided discrete converter). At the same time, one, several or all of the converter photo-converting parts (on the front side and/or reverse side) may be configured as described in any of the above described particular embodiments of the photo-converting part. In other words, even having a multilayer structure according to the invention, the photo-converting parts are not necessarily formed identically both relative to each other on the one side (for example, in case of a discrete converter) and to the photo-converting part or parts provided on the other side (in case of a unitary or discrete double-sided converter).

### DEFINITION OF TERMS AND ABBREVIATIONS

EMR means electromagnetic radiation able to form non-equilibrium charge carriers in the converter. EMR is defined by electromagnetic wave lengths of 0.005 ÷ 1000 µm, so called "optical radiation" or "optical band" characterized by efficient formation of radiant fluxes by means of optical systems, i.e. lenses, mirrors, etc. (Krutyakova M.G. et al, Semiconductor devices and basis for their design, Moscow, Radio i Svyaz Publishers, 1983, 352 pages).

Substrate means a plate made of any suitable material, whereon (wherein) the converter elements are formed. By way of example, a p-type conductivity silicon substrate is discussed below without loss of generality.

Front side (FS) of the converter means a side directly exposed to EMR.

Reverse side (RS) of the converter (or shady side) means a side opposite to the front side.

Converter base means a converter part wherein EMR is absorbed without separation of charges.

Converter emitter E means a converter element wherein the charge carriers being minor with respect to the base are accumulated.

### BRIEF DESCRIPTION OF THE DRAWINGS

The invention will be further described in terms of specific embodiments thereof with reference to the accompanying drawings wherein:
Fig. 1 shows a structure of a conventional horizontal silicon single-junction converter known in the art;
Fig. 2 shows a structure of a multilayer multijunction photo-converting part of a horizontal converter according to a possible particular embodiment of the invention (µ-PEC);
Fig. 3 shows a structural diagram of a single-sided converter with one multilayer multijunction photo-converting part according to the invention (µ-PEC);
Fig. 4 partially shows a structure of the photo-converting part of the converter shown in Fig. 3;
Fig. 5 shows a structural diagram of a planar discrete converter according to a particular embodiment of the invention;
Fig. 6 shows a structural diagram of a double-sided converter according to a particular embodiment of the invention.

The reference numerals used in the Drawings denote:
1 - semiconductor base of a first conductivity type converter (p-conductivity in the discussed examples);
1-1,1-2,...1-p - sequence of p-layers of a conductivity type identical to that of the base;
2 - emitter formed within the base and having a second conductivity type opposite to the base conductivity type (n-conductivity);
2s - near-surface heavily doped undercontact emitter layer;
2i - near-surface heavily doped emitter layer with a 2j-isotype barrier;
2-1, 2-2, ... 2-n - sequence of n-layers of a conductivity type identical to that of the emitter 2;
3-1, 3-2, ... 3-k - sequence of k homogeneous p-n junctions formed by the layers 1-1, 2-1, 1-2, 2-2 ... 1-p, 2-n; k = p + n;
3 - front side emitter-base junction;
4 - reverse side reverse side heavily doped layer of a conductivity type identical to that of the base;
5 - isotype reverse side junction (barrier);
6 - antireflection coating;
7 - contact window;
8 - front side metallization (front side current collecting electrode/electrodes);
9 - reverse side metallization (reverse side current collecting electrode/electrodes);
10 - incident radiation;
11-e - electron current paths;
11-h - hole current paths;
13 - front side buried heavily doped element of a conductivity type identical to that of the base;
14 - front side heavily doped layer of a conductivity type identical to that of the base;
15 - front side junction (barrier) of the same type as that of the base;
16 - reverse side, buried, heavily doped deflecting element of a conductivity type identical to that of the base;
17 - front side layer of the same type as the emitter, connecting the layers 2-1, 2-2, ... 2-n;
18 - isotype front side junction (barrier) with the layers 2-1, 2-2, ... 2-n;
19 - front side p-n junction.

### PREFERRED EMBODIMENTS OF THE INVENTION

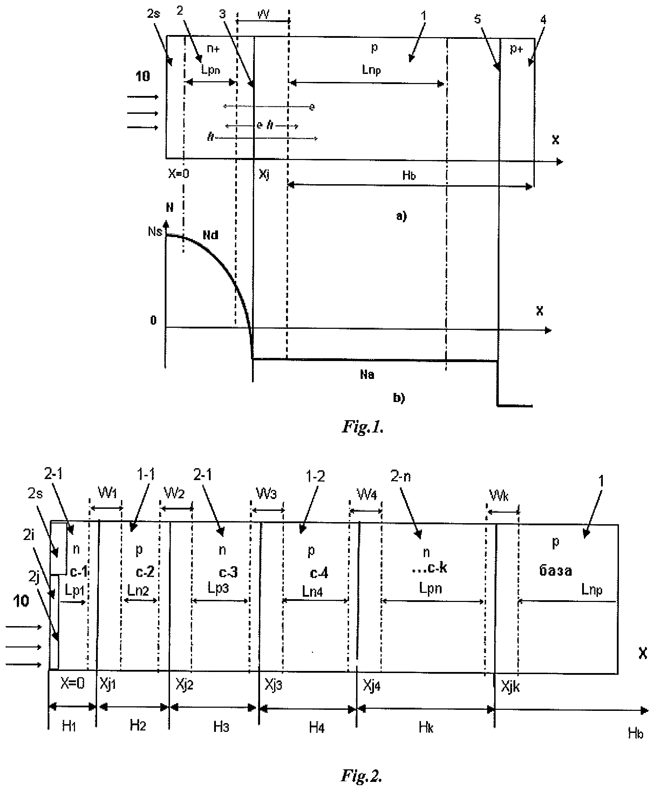

For better understanding of the invention, an example of a conventional horizontal silicon homogeneous converter known in the art, having a n⁺pp⁺ structure with a continuous n⁺ emitter layer (Fig. 1) will be first discussed. The prior art converter has a n⁺p junction of a depth Xj, width W of the space-charge region, and characteristic diffusion lengths Lpₙ, Lnₚ of the minority charge carriers. Fig. 1 also shows (a) the current paths *e* and *h* of the photo-generated electrons and holes, respectively, and (b) the expected doping profiles Nd and Na of the donor and acceptor impurities, respectively.

It is known that the total photo-electric current J(λ) generated upon absorption of light having a predetermined wavelength λ, is equal to the sum of photo-electric currents Jp(λ), Jn(λ) and Jj(λ) generated respectively in the regions of emitter 2, base 1 and junctions 3:

J(λ) = Jp(λ) + Jn(λ) + Jj(λ) (1)

The spectral response is:

S(λ) = J(λ)/qG (λ) (2)

where q is an electron charge, and G(λ)∼e^{-úx} is a relationship between the generation rate of the electron-hole pairs and the distance x = 0 from the surface, defined by the absorption factor ά(λ) typical for each of the semiconductors.

The relationship ά(x) in silicon is such that the quanta with a wavelength λ < 0.8 µm (E > 1.55 eV) are absorbed within a rather narrow near-surface region of the converter, extending less than 10 µm deep into the base region.

The spectral response of a "violet" silicon solar cell (standard converter with a thin lightly-doped emitter having a high spectral response in the short-wave spectral range) in the short-wave subspectrum is E > 25 eV (λ < 0.5 µm), i.e., 1.5 ÷ 3.0 times higher than that of a conventional cell. Its spectral response shape is close to the theoretical one at a low surface recombination rate Sp ≈ 10⁴ cm/s. With the photon energy values higher than 3.5 eV (λ < 0.35 µm), the spectral response is entirely defined by the front side layer. In the conventional cells with a buried and higher-doped n⁺ emitter layer having less diffusion lengths, the spectral response in the short-wave range approaches the theoretical value at Sp ≈ 10⁵ ÷ 10⁶ cm/s. (See Zi S., Semiconductor Physics in two volumes, Volume 2, Moscow, Mir Publishers, 1984, 456 pages, Ch. 14). The ratio of holes collected within the base formed of the emitter layer is defined by the diffusion length Lpₙ dependant, under otherwise equal conditions, on the emitter dopant profile. Some of the photons absorbed by the emitter in the near-surface layer Xj-Lpₙ recombine due to an extremely short lifetime of the non-equilibrium carriers in the heavily-doped near-surface region of this layer 2s. The higher the doping level of this layer Ns and the deeper the p-n junction Xj, the lower the spectral response in the short-wave spectral range.

The ratio of electrons collected from the base in the emitter region is defined by the electron diffusion length Lnₚ being ∼150 ÷ 250 µm for silicon. As a rule, the base thickness Hb is selected subject to the condition Hb ≤ Lnₚ and requirements for mechanical strength of the plate, and is 180 ÷ 280 µm. Despite a considerably higher ratio of photon flux in this spectral band, the contribution of the base region converter into spectral selectivity goes down sharply in the range λ ≈ 0.85 ÷ 1.1 µm (E>1,1 eV). It is due not only to a dramatic drop of the absorption factor in this range but also to an extremely low conversion factor in the waveband to the right of the narrowest maximum of the spectral selectivity of a conventional silicon PEC (λ ≈ 0.85 µm). The maximum of spectral selectivity of a "violet" PEC is wider and corresponds to the incident photons range E ≈ 2.0 ÷ 3.0 eV (λ ≈ 0.4 ÷ 0.6 µm). Spectral response at the level of 0.9 is in general observed for silicon, "violet" and conventional PECs in a rather wide energy range E ≈ 1.3 ÷ 3.3 eV (λ ≈ 0.96 ÷ 0.36 µm). The photons whose energy is within this range are absorbed near the surface, i.e., only a narrow converter band being 0.1 ÷ 40 µm wide is efficiently used.

The field in the p-n junction space-charge region (SCR) is so high that the photo-generated electrons and holes are carried out of the depletion layer as early as before having managed to recombine with each other. Therefore, the depletion layer photo-electric current in a unit spectral range is equal to the number of photons absorbed in this layer in unit time. Despite a negligibly small SCR width W relative to the base thickness Hb, the p-n junction contribution to spectral response is as high as 20% regardless the PEC class, whether "violet" or conventional.

In contrast to the prior art solutions, it is proposed in accordance with the present invention to include in the converter's photo-converting part a sequence of layers composed of the same semiconductor material (for example, silicon, gallium arsenide, germanium, etc) to form a sequence of homogeneous junctions, as shown in Fig. 2. This being the case, the number of different-type junctions should be more than one. In the illustrated example, the photo-converting part comprises the sequence c-1, c-2. c-3, c-4,..., c-k of layers having a thickness H₁, H₂, H₃, H₄, ..., Hk and forming k horizontal Xj₁, Xj₂, Xj₃, Xj₄,..., Xjk homogeneous junctions with a width W₁, W₂, W₃, W₄, ..., Wk of the space-charge region, characteristic diffusion lengths Lp₁, Ln₂,...,Lnₚ of the minority charge carriers, and the current paths *e* and *h* of photo-generated electrons and holes, respectively.

In the illustrated example, the expected dopant profile of layers is dependent on how these are formed, i.e., by diffusion, ion implantation and annealing, epitaxial overgrowth and the like or by a combination thereof. The expected doping level of layers is of no fundamental importance and is determined by the conditions for providing a maximum spectral response of a given layer in combination with the adjacent layers. In case of a low doping level of the first layer c-1, the contact area may be subdoped (layer 2s) for providing an ohmic contact. For lowering the surface recombination rate of the first layer c-1, it may be complemented on the surface thereof with an isotype layer 2i forming an isotype potential barrier 2j to prevent NeCCs from being carried out of a less doped region. The conductivity type of the first layer c-1 relative to the conductivity type of the base 1 is of no fundamental importance, and in the event of matching the conductivity types of the base and this layer, a Shockley diode (homogeneous or heterogeneous) may be formed on its surface or a local Schottky diode of the required direction or a combination of diodes.

Preferably, the thickness of each of the layers H₁, H₂, H₃, H₄, Hₖ, is commensurate with the characteristic diffusion lengths Lp₁, Ln₂, Lp₃, Ln₄,... Lpₖ of the minority charge carriers in this layer, and with due account for changes in the lifetime upon changing the exposure (intensity of the incident radiant flux, temperature, radiation, etc.), it may be greater or less that the characteristic diffusion length (the NeCC characteristic diffusion lengths determined at standard conditions correspond to the original values Lpₙ 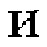 Lnₚ of the NeCC diffusion lengths in the respective layers). The front (photo-receiving) surface of the converter may be textured and may also have an antireflection coating, for example, in the form of transparent electroconductive films (ITO and the like) with a metallization grid. The non-contacting front surface of the converter may be passivated with a dielectric also serving as an antireflection coating. The dielectric may be charge-neutral or may have a positive or negative integrated charge for reducing the surface recombination rate depending on the first layer c-1 conductivity type. The metallization grid may be formed by any known method.

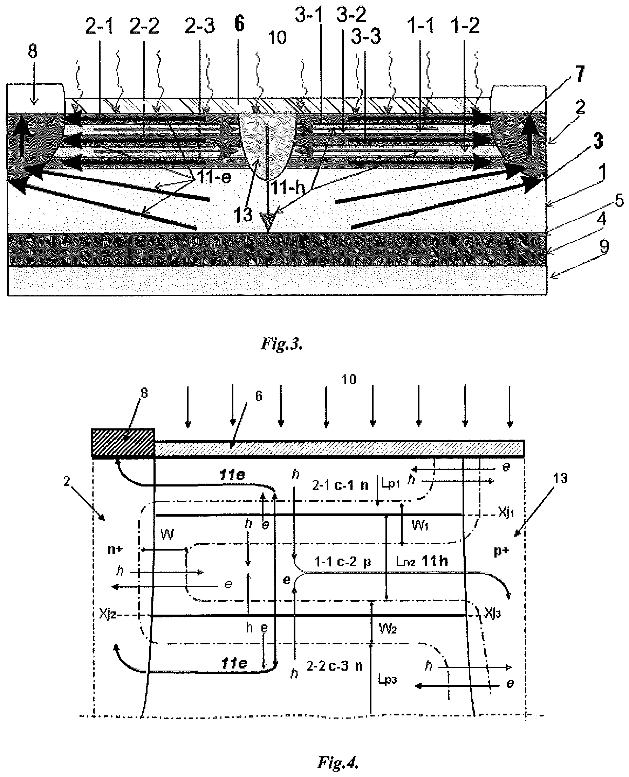

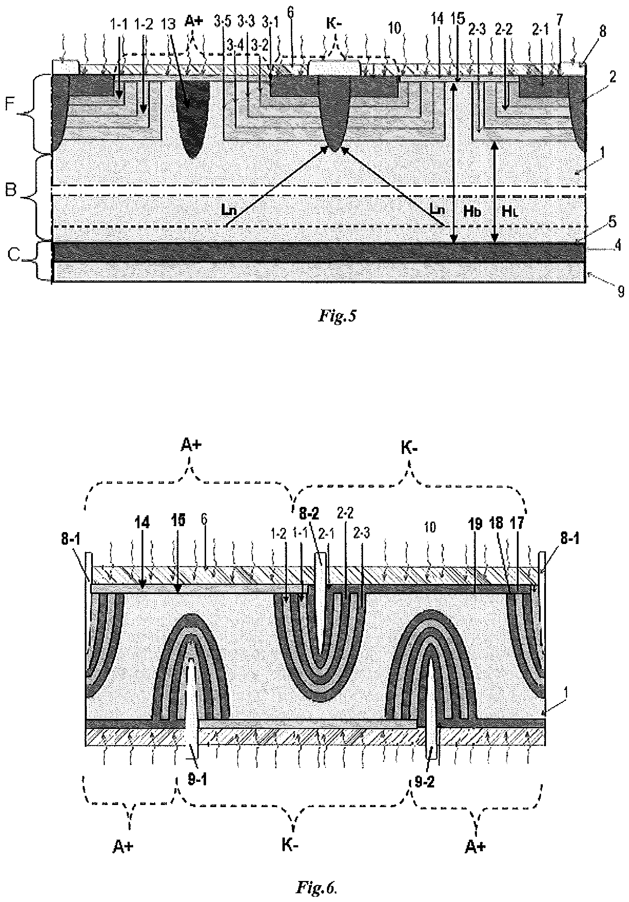

Fig. 3 shows an exemplary embodiment of a single-sided converter with one photo-converting part having the above structure according to the invention. In this example, the layers 2-1, 2-2, ... 2-n of a single conductivity type are switched into a parallel circuit (into a parallel current pack) by means of a buried connection element 2 of the same conductivity type, which may be formed for example by diffusion. As a result, the buried element 2 is connected to all or some of the layers of the same conductivity type of the converter's photo-converting part (by means of which parallel switching is performed), and forms p-n junctions with the layers 1-1, 1-2, ... 1-p of another conductivity type. This being the case, the layers 1-1, 1-2,...1-p of another conductivity type may also be switched into a parallel current pack by means of the similar buried connection element 13 of the same conductivity type (also formed for example by diffusion). In general, the buried elements 2 and 13 may have any shape suitable for solving the problem having been set. It may also be noted that in other embodiments parallel switching of the photo-converting part layers may be performed not only by means of the connection elements 2 and 13 buried deep into the photo-converting part but also by other methods. In particular, when, apart from horizontal lengths, the layers also have vertical and curved lengths so that the layers become exposed at the surface of the photo-converting part, parallel switching may be performed by means of the semiconductor elements of the same conductivity type as the layers to be switched or by means of the conductor elements disposed at the surface of the photo-converting part (such example is given below with reference to a particular embodiment illustrated in Fig. 6).

There may be embodiments wherein combining only one of the group of layers of a single conductivity type is provided: either only n-layers using the buried element 2 of the same conductivity type or only p-layers using the buried element 13 of the same conductivity type. At the same time, only some of the layers of a single conductivity type may be switched in parallel while the remaining layers of the same conductivity type not coupled (isotype or anisotype, i.e. combination switching). It is true both in case of parallel switching of layers of only one conductivity type and in the example of parallel switching of layers of both conductivity types shown in Fig. 3.

As shown in Fig. 2 and 3, the homogeneous layer being the last (deepest) in the sequence of layers in the inventive photo-converting part and forming a homogeneous junction with the preceding layer, may form a junction with the converter base. This being the case, said junction may comprise both isotype and anisotype, both homogeneous and heterogeneous junction. In addition, said last layer forming a homogeneous junction with the preceding layer may border on the additional deep layers forming the converter rather than on the base. In this case, a heterojunction or heterojunctions will be obviously formed between the last layer and the additional layer or layers adjacent thereto (since in case of a homogeneous junction this additional layer will also be part of said sequence of homogeneous layers).

It may also be noted that heterojunctions in accordance with the present invention may be formed not only along the boundary of the last (deepest) layer of the sequence of layers forming homojunctions but also along other boundaries of this sequence (for example, along the boundary of the first layer of the least depth or along the side boundary of layers forming the sequence, for example, if the elements 2 and 13 in Fig. 4 are replaced with the semiconductor elements of a different semiconductor material).

The layers 1-1, 1-2, ... 1-p and 2-1, 2-2, ... 2-n of the photo-converting part which form homogeneous junctions with each other may be provided with discontinuities in plan view and/or in some of the converter sections. At the same time, discontinuities may result not only from providing buried connection elements, as shown in Fig. 3, but also, for example, from providing "windows" on the photo-receiving surface of the converter's photo-converting part, which "windows" may comprise portions of the base 1 either not doped when producing the photo-converting part or exposed as a result of partly etching the photo-receiving surface. However, the shape, size and number of "windows" (one or more such "windows" may be provided) may be selected by a skilled person in each particular case based on the problem to be solved. At the same time, discontinuities ("windows") as such may not result in breaking a single photo-converting part into several pieces, i.e. in forming a discrete converter discussed below (any of the photo-converting parts of which, however, may also be provided with discontinuities in its layers). The discussed discontinuities in case of the unitary converter according to the invention form either a "grid" layer (if the continuity of one layer is broken) or a "grid" structure of a combination of several successive layers provided with discontinuities.

### Operating principle of the proposed converter and attainment of the technical effect

The photo-electric currents Jp(λ) and Jn(λ) generated from the quasi-neutral regions of the layers c-1, c-2, c-3, c-4,..., c-k are determined by the photon distribution through the layer thickness, effective diffusion lengths in the layers and concentration gradients of the minority charge carriers at the edges of the depletion regions. Since a sequence comprises more than one different-type junctions and each of the layers, except for the first layer c-1 and the base, is defined by p-n junctions on both sides, as shown in Figs. 2, 3 and 4, bidirectional concentration gradients occur therein, charge separation takes place so that the minority carriers drain into the adjacent layers to become the majority carriers for outputting to the external circuits through the heavily-doped common elements 2 and 13.

The electron-hole pairs generated in the space-charge regions (SCR) W₁, W₂, W₃, W₄, ..., Wₖ are separated into the adjacent quasi-neutral regions of layers by the fields of p-n junctions. The space-charge region itself is meander-shaped so that the light flux 10 has to repeatedly cross the SCR.

In the horizontal direction, each of the layers 1-1, 1-2, ..., 1-p forms a diode n⁺pp⁺ structure with the connection element 2 and each of the layers 2-1, 2-2, ..., 2-n forms a diode p⁺nn⁺ structure with the connection element 13, as shown in Figs. 3, 4. The p⁺n 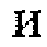 n⁺p junctions of different types having been formed, create lateral concentration gradients and enable collection of the minority charge carriers in the vicinity of the elements 2 and 13 from the opposite conductivity type layers adjacent thereto. The isotype nn⁺ and pp⁺ junctions enable the electrons to sink (lines 11-e) to the emitter region 2 and enable the holes to sink through the layer 13 (lines 11-h) to the base 1. Therefore, if seen vertically, such structure comprises a sequence of generators connected in parallel. The above described multiple-layer (multilayer or multi-element) photoelectric converters are briefly referred to by the inventors as µ-PEC.

Since such structure requires no large diffusion lengths of the NeCC in the layers and comprises k>1 junctions where charge separation takes place without loss, the collection factor therein tends to one in a wide range of the absorbed radiation. The fact that generation, separation and output of charge carriers from the generation regions occurs layer-by-layer makes it possible to use the layers with low doping levels: in contrast to the structure shown in Fig. 1, the internal series sheet resistance in the proposed structure of Fig. 2 is further distributed between the layers.

The non-equilibrium electrons generated in the base 1 by the long-wavelength spectral part are separated by the emitter 2. Since the emitter is formed as local regions, its doping level, depth and configuration may have arbitrary values. In particular, it may be buried by etching with subsequent doping as deep as permitted by the mechanical strength of the plate. Emitter metallization in this case is provided substantially on its lateral surface, i.e. buried vertical buses are formed by the contact grid.

The distance between the emitter connection elements 2 and their width may have arbitrary values varying from the standard values accepted in the designs of standard solar cells to the values commensurate with the characteristic diffusion length in the base region.

The reverse side of the converter may also be formed similar to its front side. Any prior art structural configuration is applicable to the reverse side.

Fig. 5 illustrates an exemplary embodiment of a discrete planar µ-PEC formed on a semiconductor substrate and provided with a number of isolated photo-converting parts, each or some of which parts being multilayer and multijunction in accordance with the previously described aspects of the invention. In particular, such converter comprises a set of photo-converting parts, one or more of which parts comprising a sequence of semiconductor layers made of the same semiconductor material to form a sequence of homogeneous junctions with an increasing depth (i.e., arranged in succession from the surface of the photo-converting part into the depth thereof). Said photo-converting parts may be formed as previously described, and the single-type layers (i.e. having the same conductivity type) may be switched in parallel, in series or by a combination method.

The layers switched in parallel are combined within one photo-converting part into cathode K (negatively charge) and/or anode A (positively charged) current packs. The cathode current pack K between the layers 2-1, 2-2, ... 2-n is formed by their common buried emitter connection element 2. The layers 1-1, 1-2, ... 1-p whose conductivity is of the same type as that of the base 1 are connected in parallel into the anode current pack A with a connection element 14 forming an isotype junction 15 with the base. The photo-converting parts may have different depths, widths, lengths and arbitrary cross-sectional configuration of layers. As an alternative, the photo-converting parts may be localized to small geometrical dimensions and their number at the converter surface may be increased.

The structure of the proposed discrete converter may be complemented with the element 13 provided in the base 1 to form a built-in deflection field preventing a charge recombination.

In the discrete arrangement, the spectral response in the long-wave spectral range with the energy of photons in excess of the forbidden band width is limited by the diffusion length Ln of the minority charge carriers in the base. As a rule, the base thickness Hb is selected to be less than Ln. Given the short lifetimes, the base part Hb-H_{L} is used inefficiently.

To improve the efficiency of carrier collection from the base depth without increasing the base lifetime, the depth of the emitter connection element 2 may be increased both by increasing the diffusion time and creating locally etched emitters. For this purpose, the regions of the emitter elements 2 are first etched in the silicon structure shown in Fig. 4, whereafter the emitter is doped and metallized. The etching depth is limited only by mechanical strength of the substrate. In this manner, a bulk beam-type multi-element πµ-PEC may be formed.

As an alternative, the front side structure of the discrete converter show in Fig. 5 may be modified by various techniques. For example, if in one of the photo-converting parts a layer being first in numerical order (closest to the surface) of the claimed sequence forming homogeneous junctions has the same conductivity type as that of the base (i.e., for example, p-type conductivity) and in another photo-converting part a layer being first in numerical order has a conductivity type different from that of the base (i.e., n-type conductivity), a single-sided bipolar converter may be formed by switching the p-type conductivity layers 1-1, 1-2,... in parallel with each other and with the base using the common p-type element 14 (forming the isotype junction 15 with the p-base 1), a switching the n-type conductivity layers 2-1, 2-2, 2-3,... using a common n-type element 17 (forming a p-n junction 19 with the base 1). At the same time, a similar structure (or a part thereof) may also be formed on the reverse side of the converter resulting in a double-sided converter. An example of such arrangement is shown in Fig. 6.

The current-collecting electrodes 8-1 adjacent to the first set of photo-converting parts and connected in parallel to each other will have positive polarity. The electrodes 8-2, connected in parallel to each other will have negative polarity.

The electrodes 9-1 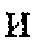 9-2 arranged on the reverse side of the multipolar double-sided discrete converter may be connected similar to the front side electrodes. The mutual arrangement of the group of elements is selected considering the NeCC effective diffusion lengths in the base.

## Claims

1. A photo-converting part of an electromagnetic radiation converter, said part comprising a sequence of layers (1-1,1-2,.....,1-p;2-1,2-2,....,2-n) forming homogeneous junctions (3-1,3-3,.....,3-k) with each other, wherein said sequence comprises more than one different-type junctions (3-1,3-3,....,3-k) wherein the photo-converting part comprises a sequence (c-1,c-2,c-3,c-4,....,c-k) of layers (1-1,1-2,....,1-p; 2-1,2-2,....,2-n) having a respective layer thickness (H₁,H₂,H₃,H₄,....Hₖ), the thickness of each of the layers (H₁,H₂,H₃,H₄,....Hₖ) is commensurate with a characteristic diffusion length (Lₚ₁,Lₚ₂,_{Lp3},Lₙ₄,....,Lₚₖ) of the minority charge carriers in this layer, **characterised in that** the layers (1-1,1-2,....,1-p; 2-1,2-2,....,2-n) of a single conductivity type are switched into a parallel circuitry by means of a buried connection element (2,13) of the same conductivity type.

2. An electromagnetic radiation converter comprising a photo-converting part as recited in claim 1 comprising at least M ≥ 1 photo-converting parts, an antireflection coating and current-collecting electrodes, **characterized in that** at least one of said M photo-converting parts comprises a sequence of layers forming homogeneous junctions with each other, said sequence comprising more than one different-type junctions with at least Z ≥ 0 of said layers of the same conductivity type of said converter's photo-converting part being switched in parallel.

3. The converter according to claim 2, **characterized in that** it comprises one photo-converting part of the above type arranged on the front side thereof.

4. The converter according to claim 2 or 3, **characterized in that** it comprises one photo-converting part of the above type arranged on the reverse side thereof.

5. The converter according to claim 2, **characterized in that** it comprises on at least one of its sides several photo-converting parts isolated from one another, at least one of which parts having the multilayer structure of the above type.

6. The converter according to claim 5, H , **characterized in that** said several isolated photo-converting parts are provided on the front side of the converter.

7. The converter according to claims 5 or 6, **characterized in that** said several isolated photo-converting parts are provided on the reverse side of the converter.

8. The converter according to claim 7, **characterized in that** all said isolated photo-converting parts have the multilayer structure of the above type.

9. The converter according to claim 8, **characterized in that** all said isolated photo-converting parts have the multilayer structure of the above type.

## Patentansprüche

1. Optisch-elektrischer Wandlerteil eines elektromagnetischen Strahlungswandlers, wobei der Teil eine Abfolge von Schichten (1-1, 1-2, ..., 1-p; 2-1, 2-2, ... 2-n) umfasst, die homogene Übergänge (3-1, 3-3, ... 3-k) miteinander bilden, wobei die Abfolge Übergänge (3-1, 3-3, ..., 3-k) mehr als eines unterschiedlichen Typs umfasst, wobei der optisch-elektrische Wandlerteil eine Abfolge (c-1, c-2, c-3, c-4, ... c-k) von Schichten (1-1, 1-2, ..., 1-p; 2-1, 2-2, ..., 2-n) umfasst, die eine jeweilige Schichtdicke (H₁, H₂, H₃, H₄,..., Hₖ) aufweisen, wobei die Dicke jeder der Schichten (H₁, H₂, H₃, H₄, ..., Hₖ) einer charakteristischen Diffusionslänge (Lₚ₁, Lₚ₂, Lp₃, Lₙ₄, ..., Lₚₖ) der Minoritätsladungsträger in dieser Schicht entspricht, **dadurch gekennzeichnet, dass** die Schichten (1-1, 1-2, ..., 1-p; 2-1, 2-2, ..., 2-n) eines einzelnen Leitfähigkeitstyps mittels eines vergrabenen Verbindungselements (2, 13) des gleichen Leitfähigkeitstyps zu einer Parallelschaltung verschaltet sind.

2. Elektromagnetischer Strahlungswandler, der einen optisch-elektrischen Wandlerteil nach Anspruch 1 umfasst, der mindestens M ≥ 1 optisch-elektrischen Wandlerteile, eine Antireflexbeschichtung und Stromsammelelektroden umfasst, **dadurch gekennzeichnet, dass** mindestens einer der M optisch-elektrischen Wandlerteile eine Abfolge von Schichten umfasst, die homogene Übergänge miteinander bilden, wobei die Abfolge Übergänge mehr als eines unterschiedlichen Typs umfasst, wobei mindestens Z ≥ 0 der Schichten des gleichen Leitfähigkeitstyps des optisch-elektrischen Wandlerteils des Wandlers parallelgeschaltet sind.

3. Wandler nach Anspruch 2, **dadurch gekennzeichnet, dass** er einen optisch-elektrischen Wandlerteil des obigen Typs umfasst, der an der Vorderseite desselben angeordnet ist.

4. Wandler nach Anspruch 2 oder 3, **dadurch gekennzeichnet, dass** er einen optisch-elektrischen Wandlerteil des obigen Typs umfasst, der auf der Rückseite desselben angeordnet ist.

5. Wandler nach Anspruch 2, **dadurch gekennzeichnet, dass** er auf mindestens einer seiner Seiten mehrere voneinander isolierte optisch-elektrische Wandlerteile umfasst, wobei mindestens einer dieser Teile die mehrschichtige Struktur des obigen Typs aufweist.

6. Wandler nach Anspruch 5, **dadurch gekennzeichnet, dass** die mehreren isolierten optisch-elektrische Wandlerteile auf der Vorderseite des Wandlers vorgesehen sind.

7. Wandler nach den Ansprüchen 5 oder 6, **dadurch gekennzeichnet, dass** die mehreren isolierten optisch-elektrischen Wandlerteile auf der Rückseite des Wandlers vorgesehen sind.

8. Wandler nach Anspruch 7, **dadurch gekennzeichnet, dass** alle die isolierten optisch-elektrischen Wandlerteile die mehrschichtige Struktur des obigen Typs aufweisen.

9. Wandler nach Anspruch 8, **dadurch gekennzeichnet, dass** alle die isolierten optisch-elektrischen Wandlerteile die mehrschichtige Struktur des obigen Typs aufweisen.

## Revendications

1. Partie de conversion photoélectrique d'un convertisseur de rayonnement électromagnétique, ladite partie comprenant une séquence de couches (1-1, 1-2, ..., 1-p ; 2-1, 2-2, ..., 2-n) formant une séquence de jonctions homogènes (3-1, 3-3, ..., 3-k) entre elles, dans laquelle ladite séquence comprend plusieurs jonctions de type différent (3-1, 3-3, ..., 3-k), dans laquelle la partie de conversion photoélectrique comprend une séquence (c-1, c-2, c-3, c-4, ..., c-k) de couches (1-1, 1-2, ..., 1-p ; 2-1, 2-2, ..., 2-n) ayant une épaisseur de couche (H₁, H₂, H₃, H₄, ..., Hₖ), l'épaisseur de chacune des couches (H₁, H₂, H₃, H₄, ..., Hₖ) est proportionnelle à une longueur de diffusion caractéristique (Lₚ₁, Lₚ₂, Lp₃, Lₙ₄, ..., Lₚₖ) des porteurs de charge minoritaires dans cette couche, **caractérisée en ce que** les couches (1-1, 1-2, ..., 1-p ; 2-1, 2-2, ..., 2-n) d'un seul type de conductivité sont commutées en un ensemble de circuits en parallèle au moyen d'un élément de connexion enterré (2, 13) du même type de conductivité.

2. Convertisseur de rayonnement électromagnétique comprenant une partie de conversion photoélectrique selon la revendication 1, comprenant au moins M ≥ 1 parties de conversion photoélectrique, un revêtement antireflet et des électrodes de collecte de courant, **caractérisé en ce qu'**au moins une desdites M parties de conversion photoélectrique comprend une séquence de couches formant entre elles des jonctions homogènes, ladite séquence comprenant plusieurs jonctions de type différent avec au moins Z ≥ 0 desdites couches du même type de conductivité de ladite partie de conversion photoélectrique du convertisseur commutées en parallèle.

3. Convertisseur selon la revendication 2, **caractérisé en ce qu'**il comprend une partie de conversion photoélectrique du type ci-dessus agencée sur le côté avant de celui-ci.

4. Convertisseur selon la revendication 2 ou 3, **caractérisé en ce qu'**il comprend une partie de conversion photoélectrique du type ci-dessus agencée sur le côté arrière de celui-ci.

5. Convertisseur selon la revendication 2, **caractérisé en ce qu'**il comprend sur au moins un de ses côtés des parties de conversion photoélectrique isolées les unes des autres, au moins une de ces parties ayant la structure multicouche du type ci-dessus.

6. Convertisseur selon la revendication 5, **caractérisé en ce que** lesdites parties de conversion photoélectrique isolées sont prévues sur le côté avant du convertisseur.

7. Convertisseur selon les revendications 5 ou 6, **caractérisé en ce que** lesdites plusieurs parties de conversion électrique isolées sont prévues sur le côté arrière du convertisseur.

8. Convertisseur selon la revendication 7, **caractérisé en ce que** l'ensemble desdites parties de conversion photoélectrique ont la structure multicouche du type ci-dessus.

9. Convertisseur selon la revendication 8, **caractérisé en ce que** l'ensemble desdites parties de conversion photoélectrique ont la structure multicouche du type ci-dessus.
